Europäisches Patentamt

European Patent Office

Office européen des brevets

(11) Veröffentlichungsnummer: **0 343 369**
**A1**

## (12) EUROPÄISCHE PATENTANMELDUNG

(21) Anmeldenummer: 89106888.4

(22) Anmeldetag: 18.04.89

(51) Int. Cl.4: **H01L 21/263 , H01L 29/32 , H01L 29/74 , H01L 29/10**

(30) Priorität: 19.05.88 DE 3817160

(43) Veröffentlichungstag der Anmeldung: 29.11.89 Patentblatt 89/48

(84) Benannte Vertragsstaaten:
CH DE FR GB IT LI SE

(71) Anmelder: **Siemens Aktiengesellschaft Wittelsbacherplatz 2 D-8000 München 2(DE)**

(72) Erfinder: **Voss, Peter, Dr. Rudliebstrasse 42 D-8000 München 81(DE)**

(54) **Verfahren zum Herstellen eines Thyristors.**

(57) Es ist bekannt, einen Thyristor dadurch überkopfzündfest zu machen, daß im Halbleiterkörper (1) des Thyristors ein Bereich (A) erzeugt wird, der im Vergleich zum übrigen Halbleiterkörper eine geringere Durchbruchsspannung aufweist. Dieser Bereich wird bei Überlastung des Thyristors durch geeignete Maßnahmen geschützt. Die Erfindung schlägt ein Verfahren vor, bei dem der Bereich (A) des Halbleiterkörpers (1) lokal mit Protonen bestrahlt wird, die Protonenenergie dabei so bemessen wird, daß das Maximum der durch die Protonenbestrahlung erzeugten Störstellendichte und Dotierung zwischen dem pn-Übergang (15) der ersten Basiszone (9) und zweiten Basiszone (10) und der halben Dicke der zweiten Basiszone (10) liegt, und der Halbleiterkörper (1) anschließend getempert wird.

FIG 1

## Verfahren zum Herstellen eines Thyristors

Die Erfindung betrifft ein Verfahren zum Herstellen eines Thyristors mit einem Halbleiterkörper, der einen Bereich enthält, der im Vergleich zum übrigen Halbleiterkörper eine geringere Durchbruchsspannung aufweist, wobei der Halbleiterkörper mindestens eine mit einer Steuerelektrode versehene erste Hauptfläche, eine zweite Hauptfläche und eine mit der Steuerelektrode verbundene erste Basiszone mit angrenzender zweiter Basiszone aufweist.

Solche Verfahren sind z.B. aus der DE-OS 23 00 754 bekannt und dienen dazu eine kontrollierbare Überkopfzündung des Thyristors in diesem Bereich bei der vorgegebenen geringeren Durchbruchspannung zu ermöglichen. Der Bereich, der im Vergleich zum übrigen Halbleiterkörper des Thyristors eine geringere Durchbruchsspannung aufweist, wird in dieser Veröffentlichung z. B. dadurch hergestellt, daß die zweite Basiszone in diesem Bereich dünner als außerhalb dieses Bereiches ausgebildet ist.

In der DE-OS 23 46 205 ist beschrieben, den Bereich geringerer Durchbruchsspannung im Halbleiterkörper dadurch zu bilden, daß speziell solche Halbleiterscheiben als Ausgangsmaterial für den Halbleiterkörper ausgewählt werden, die in definierter Weise einen Bereich mit niedrigeren spezifischen Widerstand aufweisen. Solche Halbleiterscheiben lassen sich z.B. durch einen besonderen Silizium-Ziehprozeß herstellen.

Eine weitere Möglichkeit am Rand des Halbleiterkörpers einen Bereich anzuordnen, der im Vergleich zum übrigen Halbleiterkörper eine niedrigere Durchbruchsspannung aufweist, besteht z.B. darin, daß die Randkontur des Halbleiterkörpers mit einem negativen Winkel versehen wird.

Diese bekannten Verfahren haben den Nachteil, daß sie häufig nur mit unbefriedigender Ausbeute anzuwenden sind. Der Erfindung liegt die Aufgabe zugrunde, ein Verfahren anzugeben, mit dem es möglich ist, an einer bereits vorliegenden Thyristortablette nachträglich einen Bereich zu erzeugen, der im Vergleich zum übrigen Halbleiterkörper der Thryistortablette eine geringere Durchbruchsspannung aufweist.

Diese Aufgabe wird dadurch gelöst, daß eine Hauptfläche des Halbleiterkörpers in diesem Bereich aus einer Protonenstrahlquelle mit Protonen bestrahlt wird, daß die Protonenenergie so bemessen wird, daß das Maximum der durch die Protonenbestrahlung erzeugten Störstellendichte und Dotierung zwischen dem pn-Übergang der ersten Basiszone und der zweiten Basiszone und der halben Dicke der zweiten Basiszone liegt, und daß der Halbleiterkörper nach der Protonenbestrahlung getempert wird.

Weiterbildungen der Erfindung sind Gegenstand der Unteransprüche.

Besonders vorteilhaft bei unserem erfindungsgemäßen Verfahren ist, daß am bereits mit Elektroden versehenen Halbleiterkörper des Thyristors - also an der bereits fertiggestellten Thyristortablette - nachträglich ein Bereich gebildet werden kann, der im Vergleich zum übrigen Halbleiterkörper eine geringere Durchbruchsspannung aufweist. Beim lokalen Protonenbestrahlen ist nur eine Ausheiltemperatur von 250°C bis 350°C notwendig. Bei dieser niedrigen Temperatur wird der Halbleiterkörper mindestens zwei Stunden getempert. Durch diese niedrige Ausheiltemperatur wird wirksam verhindert, daß die am Halbleiterkörper bereits angebrachten Elektroden auf den Halbleiterkörper aufschmelzen oder die bereits am Halbleiterkörper angebrachte Passivierungsschicht beschädigt wird.

Das erfindungsgemäße Verfahren wird im folgenden anhand von drei Figuren näher erläutert. Es zeigen:

FIG 1 einen ersten Halbleiterkörper eines Thyristors mit einem durch Protonenbestrahlung erzeugten Bereich niedrigerer Durchbruchspannung,

FIG 2 die Feldstärkeverteilung E (x) im Bereich des Halbleiterkörpers längs der Achse II - II in FIG 1, und

FIG 3 einen zweiten Halbleiterkörper eines Thyristors mit einem durch Protonenbestrahlung erzeugten Bereich niedrigerer Durchbruchsspannung,

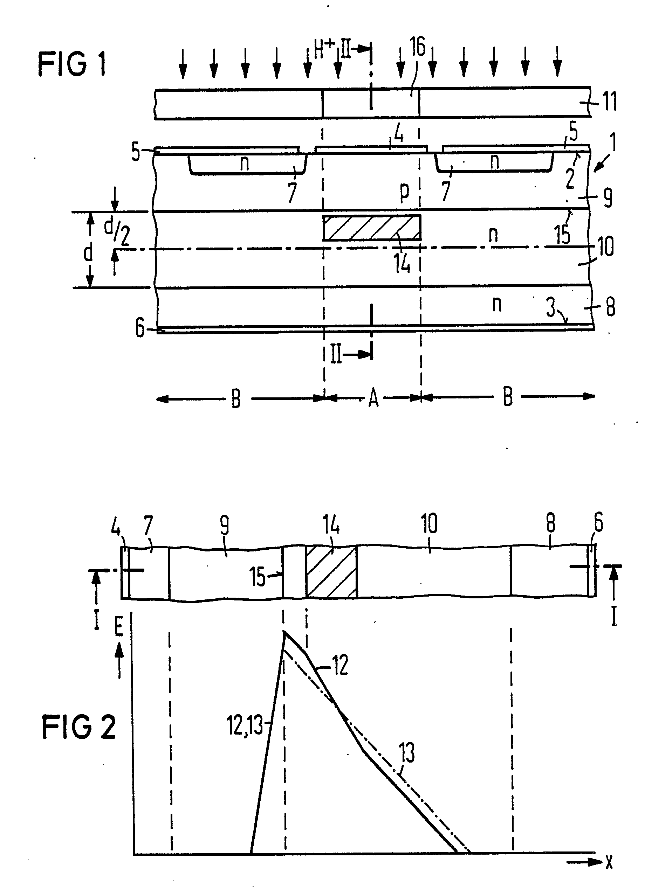

Der in FIG 1 dargestellte Halbleiterkörper 1 eines Thyristors weist zwischen seiner ersten Hauptfläche 2 und seiner zweiten Hauptfläche 3 mindestens teilweise vier Zonen jeweils abwechselnden Leitfähigkeitstyps auf. Die vier Zonen jeweils abwechselnden Leitfähigkeitstyps sind eine erste Emitterzone 7, eine an diese Emitterzone angrenzende erste Basiszone 9, eine mit dieser ersten Basiszone 9 einen pn-Übergang 15 bildende zweite Basiszone 10 mit der Dicke d, an die eine zweite Emitterzone 8 grenzt. Die erste Emitterzone 7, die in diesem Ausführungsbeispiel planar in die erste Basiszone 9 eingebettet ist, ist an der ersten Hauptfläche 2 mit einer ersten Emitterelektrode 5 verbunden. Die erste Basiszone 9 steht mit einer Steuerelektrode 4 in Kontakt, die ebenfalls an der Hauptfläche 2 angeordnet ist. Eine zweite Emitterelektrode 6 ist mit der zweiten Emitterzone 8 verbunden. In dem Beispiel nach FIG 1 ist die erste Emitterzone 7 und die zweite Basiszone 10 n-dotiert, während die erste Basiszone 9 und die zweite Emitterzone p-dotiert sind.

Das erfindungsgemäße Verfahren sieht vor, in diesem Halbleiterkörper 1 einen Bereich zu bilden, der im Vergleich zum übrigen Halbleiterkörper 1 eine geringere Durchbruchsspannung aufweist. In dem in FIG 1 dargestellten Ausführungsbeispiel soll dieser Bereich niedrigerer Durchbruchsspannung in dem durch A gekennzeichneten Teil des Halbleiterkörpers 1 gebildet werden. Der übrige Teil des Halbleiterkörpers 1 ist mit B bezeichnet. Die Steuerelektrode 4 befindet sich in dem Ausführungsbeispiel nach FIG 1 innerhalb dieses Bereiches A des Halbleiterkörpers. Zur lokalen Protonenbestrahlung des Halbleiterkörpers 1 ist zwischen einer in der FIG. 1 nicht dargestellten Protonenstrahlquelle und der Hauptfläche 2 eine Abschirmvorrichtung 11 angeordnet. Die Abschirmvorrichtung 11 weist eine Öffnung 16 auf, durch die die Protonenstrahlung H$^+$ allein den dafür vorgesehenen Bereich A der ersten Hauptfläche 2 des Halbleiterkörpers erreicht. Der Durchmesser der Öffnung 16 ist in diesem Beispiel etwas kleiner als der Durchmesser der Steuerelektrode 4 gewählt, so daß die erste Emitterzone 7 nicht mit Protonen bestrahlt wird. Die Protonenenergie wird so bemessen, daß das Maximum der durch die Protonenbestrahlung erzeugten Störstellendichte und Dotierung zwischen dem pn-Übergang 15 der ersten Basiszone 9 und der zweiten Basiszone 10 und der halben Dicke d/2 der zweiten Basiszone 10 liegt. Die Protonendosis wird so bemessen, daß die im Vergleich zum übrigen Halbleiterkörper B geforderte geringere Durchbruchsspannung im Bereich A erreicht wird. Nach der Protonenbestrahlung wird der Halbleiterkörper 1 getempert. Vorzugsweise geschieht dies mindestens zwei Stunden bei einer Temperatur zwischen 250°C und 350°C.

Die Protonendosis liegt an der Hauptfläche 2 vorteilhafterweise zwischen $10^{11}$ und $10^{13}$ Protonen/cm², je nachdem, welche geforderte Durchbruchsspannung erreicht werden soll. Die Protonenenergie liegt zwischen 2 und 6 MeV.

Sollen die Protonen in den Halbleiterkörper z. B. 200 μm eindringen, so ist eine Beschleunigungsenergie von etwa 5 MeV notwendig. Wie die Beschleunigungsenergie der Protonen von der Eindringtiefe abhängig ist, ist z.B. aus der US-PS 4 056 408 bekannt.

Durch die gewählte Protonenenergie der Protonenstrahlung wird also erreicht, daß die Protonen den pn-Übergang 15 durchdringen und kurz hinter diesem zur Ruhe kommen. In diesem Abbremsbereich 14 wird die größte Störstellendichte und Dotierung erzeugt. Seine Breite beträgt etwa 10 % der mittleren Eindringtiefe.

In FIG 2 ist die Feldstärkeverteilung im Bereich des Halbleiterkörpers 1 nach FIG 1 längs der eingezeichneten Achse II - II dargestellt. Die durch die Protonenbestrahlung erzeugte Dotierung führt zu einer Feldstärkeverteilung E (x) in der Raumladungszone, wie diese durch die durchgezogene Kurve 12 dargestellt ist. Die in FIG 2 dargestellte punktiert-strichlierte Kurve 13 zeigt die Feldstärkeverteilung E (x) im nicht mit Protonbestrahlung behandelten Halbleiterkörper 1. Im Abbremsbereich 14 ist der Feldstärkegradient nach der Poisson-Beziehung größer als im übrigen Teil der zweiten Basiszone 10. Dementsprechend wird die Durchbruchfeldstärke im Bereich A früher erreicht als im Bereich B. Durch die erfindungsgemäße Protonenbestrahlung dehnt sich zwar die Raumladungszone in der zweiten Basiszone 10 etwas weniger aus. Durch den damit größeren Abstand zur zweiten Emitterzone 8 wird zwar die Teiltransistorenverstärkung des Thyristors etwas vermindert und die Transistorsperrspannung angehoben. Dies wird jedoch durch ein erhöhtes Niveau der Ladungsträgergeneration im Abbremsbereich 14 ausgeglichen und überkompensiert.

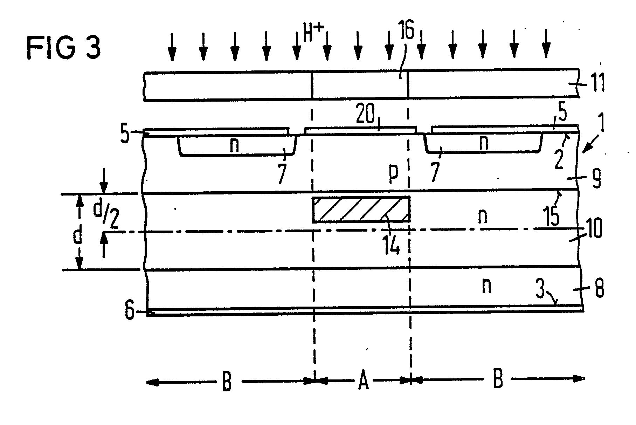

In FIG 3 ist ein zweiter Halbleiterkörper eines Thyristors dargestellt. Die in dieser FIG 3 verwendeten gleichen Bezugszeichen wie in FIG 1 bezeichnen gleiche Teile. Der Unterschied zum Halbleiterkörper in FIG 1 besteht darin, daß jetzt eine Hilfssteuerelektrode 20 im Bereich niedrigerer Durchbruchspannung angeordnet ist. Die Steuerelektrode ist nicht dargestellt.

## Ansprüche

1. Verfahren zum Herstellen eines Thyristors mit einem Halbleiterkörper (1), der einen Bereich (A) enthält, der im Vergleich zum übrigen Halbleiterkörper eine geringere Durchbruchsspannung aufweist, wobei der Halbleiterkörper (1) mindestens eine mit einer Steuerelektrode (4) versehene erste Hauptfläche (2), eine zweite Hauptfläche (3) und eine mit der Steuerelektrode (4) verbundene erste Basiszone (9) mit angrenzender zweiter Basiszone (10) aufweist, **dadurch gekennzeichnet,** daß eine Hauptfläche (2, 3) des Halbleiterkörpers (1) in diesem Bereich aus einer Protonenstrahlquelle mit Protonen bestrahlt wird, daß die Protonenenergie so bemessen wird, daß das Maximum der durch die Protonenbestrahlung erzeugten Störstellendichte und Dotierung zwischen dem pn-Übergang (15) der ersten Basiszone (9) und der zweiten Basiszone (10) und der halben Dicke d/2 der zweiten Basiszone (10) liegt, daß der Halbleiterkörper (1) nach der Protonenbestrahlung getempert wird.

2. Verfahren nach Anspruch 1, **dadurch gekennzeichnet,** daß der Halbleiterkörper (1) mindestens zwei Stunden bei einer Temperatur zwischen 250°C und 350°C getempert wird.

3. Verfahren nach einem der Ansprüche 1 oder 2, **dadurch gekennzeichnet,** daß zwischen der Protonenstrahlquelle und einer Hauptfläche (2, 3) des Halbleiterkörpers (1) eine Abschirmvorrichtung (11) derart angeordnet wird, daß nur der zum Bereich (A) gehörende Teile der Hauptfläche (2, 3) mit Protonen bestrahlt wird.

4. Verfahren nach einem der Ansprüche 1 bis 3, **dadurch gekennzeichnet,** daß die Protonendosis an der Hauptfläche zwischen $10^{11}$ und $10^{13}$ Protonen/cm$^2$ eingestellt wird.

5. Verfahren nach einem der Ansprüche 1 bis 4, **dadurch gekennzeichnet,** daß die Protonenenergie an der bestrahlten Hauptfläche (2, 3) zwischen 2 und 6 MeV eingestellt wird.

6. Verfahren nach einem der Ansprüche 1 bis 5, **dadurch gekennzeichnet,** daß der Bereich (A) niedrigerer Durchbruchsspannung so gewählt wird, daß die Steuerelektrode (4) in diesem Bereich (A) liegt.

7. Verfahren nach einem der Ansprüche 1 bis 5, **dadurch gekennzeichnet,** daß als Thyristor ein Thyristor mit Hilfssteuerelektrode (20) vorgesehen ist, daß der Bereich (A) niedrigerer Durchbruchsspannung so gewählt wird, daß die Hilfssteuerelektrode (20) in diesem Bereich (A) liegt.

FIG 1

FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DE-A-3 117 202 (BBC) <br> * Seite 9, Zeile 6 - Seite 11, Zeile 24; Figur 4 * | 1,4,5 | H 01 L 21/263 <br> H 01 L 29/32 <br> H 01 L 29/74 <br> H 01 L 29/10 |
| A | --- | 2 | |
| A | EP-A-0 014 516 (WESTINGHOUSE ELECTRIC CORP.) <br> * Seite 5, Zeilen 13-17; Figur 7; Seite 12, Zeile 37 - Seite 13, Zeile 16 * <br> --- | 1,3,6,7 | |
| A | DE-A-3 339 393 (LICENTIA PATENTVERWALTUNGS-GmbH) <br> * Seite 7, Zeilen 25-38 * <br> --- | 1,2,5 | |
| A | DE-A-3 733 100 (MITSUBISHI DENKI K.K.) <br> * Figur 1; Seite 2, Zeile 59 - Seite 3, Zeile 60 * <br> --- | 1,5 | |
| A | PATENT ABSTRACTS OF JAPAN, Band 12, Nr. 106 (E-596)[2953], 6. April 1988; & JP-A-62 235 782 (TOYOTA CENTRAL RES. & DEV. LAB. INC.) 15-10-1987 <br> * Zusammenfassung; Figur 3 * & US-A-4 752 818 (TOYOTA); Figur 3; Seite 7, Zeile 47 - Seite 8, Zeile 19 <br> --- | 1,4 | RECHERCHIERTE SACHGEBIETE (Int. Cl.4) <br><br> H 01 L |
| P,A | EP-A-0 297 325 (MITSUBISHI) <br> * Figur 5; Seite 5, Zeilen 43-51; Seite 4, Zeile 3 - Seite 5, Zeile 2 * <br> ----- | 1 | |

Der vorliegende Recherchenbericht wurde für alle Patentansprüche erstellt

| Recherchenort | Abschlußdatum der Recherche | Prüfer |
|---|---|---|
| DEN HAAG | 23-08-1989 | GELEBART J.F.M. |